# EUROPÄISCHE PATENTSCHRIFT

(11) **EP 3 327 935 B1**
(45) Veröffentlichungstag und Bekanntmachung des Hinweises auf die Patenterteilung: **28.10.2020**
(21) Anmeldenummer: 16200243.0
(22) Anmeldetag: 23.11.2016
(51) Int. Cl.: H03K 17/965, G08B 21/04, G08B 21/22, H03K 17/96

(54) **SENSOR ZUR ERFASSUNG DER BELEGUNG VON SITZ- UND LIEGEMÖBELN**
SENSOR FOR RECORDING THE OCCUPANCY OF SEATING AND RECLINING FURNITURE
CAPTEUR DE DÉTECTION D'OCCUPATION DE SIÈGES ET DE LITS

(43) Veröffentlichungstag der Anmeldung: 30.05.2018
(73) Patentinhaber: IQfy GmbH, 58540 Meinerzhagen (DE)
(72) Erfinder: Thometzek, Andreas, 58540 Meinerzhagen (DE)
(74) Vertreter: Patentanwälte Dörner & Kötter PartG mbB

(56) Entgegenhaltungen:
- WO-A2-03/005388

## Beschreibung

Die Erfindung betrifft einen Sensor zur Erfassung der Belegung von Sitz- und Liegemöbeln, die ein Sitz- oder Liegepolster aufweisen, der aus einem Gehäuse und einem dazu beweglich angeordneten Deckel besteht, wobei zwischen Gehäuse und Deckel mindestens ein Federelement angeordnet ist, und der eine Auslöseeinheit aufweist, die mit einem Sender verbunden ist.

Die Überwachung der Belegung von Sitz- und Liegemöbeln ist inzwischen weit verbreitet. Sie erfolgt bspw. mit Hilfe selbst angetriebenen Schaltsystemen, wie sie aus der WO 03/005388 A2 bekannt sind. Hintergrund für die Überwachung ist, Energieverbraucher in Abhängigkeit von der Belegung der jeweiligen Möbel und des Raums, in dem sich das Möbelstück befindet, ein- und auszuschalten, wodurch eine erhebliche Energieersparnis erreicht werden kann. Dies hat sich insbesondere in Bürogebäuden als vorteilhaft herausgestellt, da ohne die Überwachungseinrichtungen während der üblichen Bürozeiten die Energieverbraucher, wie beispielsweise Beleuchtung, Drucker oder dergleichen dauerhaft eingeschaltet sind und daher unnötige Energie verbrauchen, soweit der jeweilige Raum nicht belegt ist. Aber auch in Hotels kann die Überwachung der Betten zur Einsparung von Energie führen. Das gleiche gilt für Krankenhäuser, Alten- und Pflegeheime, bei denen eine Überwachung von großer Bedeutung ist, um ein Höchstmaß an Betreuung bereitstellen zu können.

Die Überwachung der Belegung von Sitz- und Liegemöbeln mit Hilfe der oben genannten Sensoren erfolgt zuverlässig. Es hat sich jedoch herausgestellt, dass eine Vielzahl von Polstern, insbesondere die Matratzen von Kranken- und Pflegebetten oder Matratzen in Hotels, eine relativ große Höhe aufweisen. Um ein sicheres Auslösen der bekannten Sensoren zu gewährleisten, ist es daher erforderlich, entweder den Sensor unmittelbar unter der Oberfläche der Matratzen zu positionieren, wodurch jedoch der Liegekomfort beeinträchtigt ist, oder den Sensor mit Hilfskonstruktionen zu betreiben. So ist es bekannt, die Sensoren in Einschüben zu platzieren, die mit Bügeln oder dergleichen versehen sind, die die Belegung detektieren und an den Sensor weiterleiten. Dies hat sich in der Praxis wegen des konstruktiv hohen Aufwands sowie der damit verbundenen Kosten nicht bewährt.

Hinzu kommt beim Einsatz in Krankenhäusern sowie Alten- und Pflegeheimen, dass die Polster häufig gereinigt und desinfiziert werden müssen. Diese Reinigung und Desinfektion der Polster erfolgt in der Regel in Autoklaven, in denen die Polster für einen bestimmten Zeitraum auf über 100°C bei einem Druck von ca. 2 bar in Wasserdampf erhitzt werden. Die Reinigung und Desinfektion mit Hilfe von Wasserdampf erfordert jedoch die Verwendung von gegen Wasser abgedichteten Sensoren, um eine dauerhafte Funktionssicherheit zu gewährleisten.

Um diesen Anforderungen gerecht zu werden, wurden vollständig abgedichtete Sensoren entwickelt, bei denen der Sensor von einer Schutzhülle umgeben ist, um das Eindringen von Flüssigkeit zu vermeiden. Es hat sich jedoch erwiesen, dass die Schutzhülle den Sensor hemmt, so dass ein Ausfedern nicht zuverlässig gewährleistet ist. Dies hat seine Ursache darin, dass durch Betätigen des Sensors die darin enthaltene Luft herausgedrückt wird. Nach Entlasten des Sensors, dichtet die Schutzhülle den Sensor wieder ab. Der dadurch entstehende Unterdruck innerhalb des Sensors verhindert eine Rückstellung und damit eine fehlerfreie Funktion.

Hier will die Erfindung Abhilfe schaffen. Der Erfindung liegt die Aufgabe zugrunde, einen Sensor zur Erfassung der Belegung von Sitz- und Liegemöbeln zu schaffen, der einerseits eine einwandfreie Funktion gewährleistet, ohne den Liegekomfort negativ zu beeinflussen oder Hilfskonstruktionen zu benötigen, und gleichzeitig ausreichend gegen Flüssigkeiten beim Reinigen und Desinfizieren der Polster abgedichtet ist. Gemäß der Erfindung wird diese Aufgabe durch die Merkmale des Anspruchs 1 gelöst.

Mit der Erfindung ist ein Sensor zur Erfassung der Belegung von Sitz- und Liegemöbeln geschaffen, der einerseits eine einwandfreie Funktion gewährleistet, ohne den Liegekomfort negativ zu beeinflussen oder Hilfskonstruktionen zu benötigen, und gleichzeitig ausreichend gegen Flüssigkeiten beim Reinigen und Desinfizieren der Polster abgedichtet ist.

Durch die ringförmige Ausbildung und die dadurch mögliche Auslösung über 360° bewirkt ein an beliebiger Stelle auf den Deckel ausgeübter Druck die Auslösung des Sensors.

Bevorzugt ist der Aktor benachbart zum Sender angeordnet. Hierdurch ist eine sehr geringe Bauhöhe für den Sensor ermöglicht. Denn anders als bei den aus dem Stand der Technik bekannten Sensoren, bei denen der Sender üblicherweise unter dem Aktor angeordnet ist, kann durch die nebeneinander gewählte Anordnung der Sensor um die Höhe des Senders niedriger ausfallen.

Vorteilhaft übergreift der Deckel das Gehäuse bereichsweise. Durch das Übergreifen ist das Innere des Sensors gegen Staub und Zugriff geschützt.

In anderer Weiterbildung der Erfindung weist das Gehäuse außen einen umlaufenden Ring auf, der mit Rastnasen am Deckel korrespondiert. Die Korrespondenz zwischen dem Ring und den Rastnasen bewirkt eine Begrenzung beim Ausfedern des Sensors.

Äußerst bevorzugt sind der Ring und die Rastnasen jeweils mit Einlaufschrägen versehen. Die Einlaufschrägen bewirken beim Zusammenbau des Sensors eine Erleichterung der Montage.

Andere Weiterbildungen und Ausgestaltungen der Erfindung sind in den übrigen Unteransprüchen angegeben. Ein Ausführungsbeispiel der Erfindung ist in der Zeichnung dargestellt und wird nachfolgend im Einzelnen beschrieben. Es zeigen:

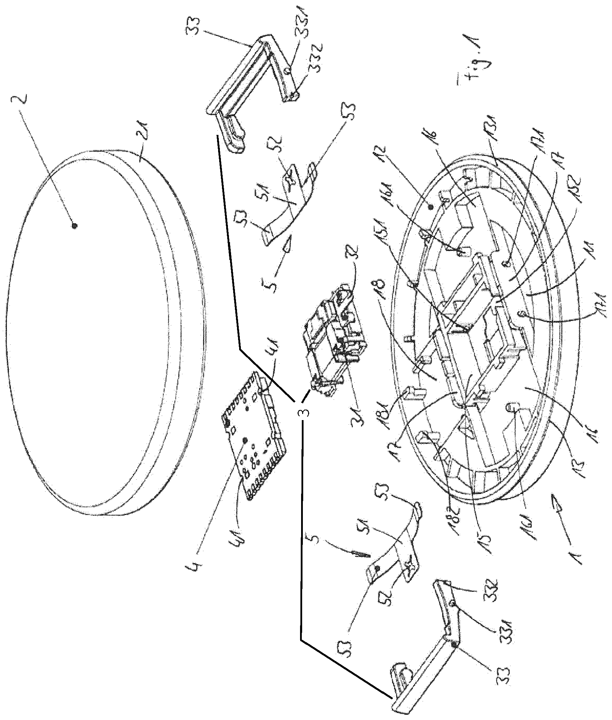

- Fig. 1: die explosionsartige Darstellung eines Sensors;

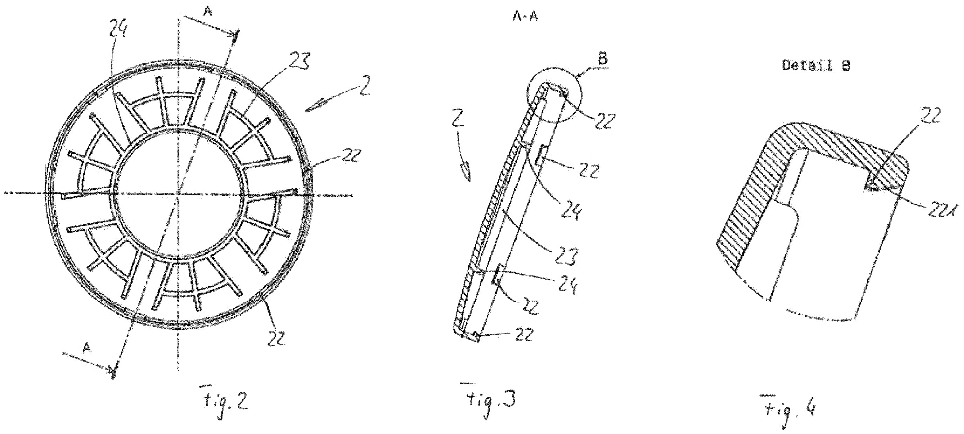

- Fig. 2: die Untersicht auf den Deckel des Sensors;
- Fig. 3: den Schnitt entlang der Linie A-A in Figur 2;
- Fig. 4: die vergrößerte Darstellung des Details "B" in Figur 3.

Der erfindungsgemäße Sensor dient zur Erfassung der Belegung von Sitz- und Liegemöbeln, die ein Sitz- oder Liegepolster aufweisen. Sitzpolster im Sinne der vorliegenden Erfindung können fest an dem jeweiligen Möbel angebrachte Polster sein. Das Polster kann aber auch lose nach Art eines Sitzkissens sein. Bei den Sitzmöbeln kann es sich um Stühle, Sofas, Hocker oder dergleichen handeln. Die Liegepolster sind in der Regel Matratzen. Aber auch Matratzen-Auflagen, Topper usw. bilden Liegepolster im Sinne der vorliegenden Erfindung. Der erfindungsgemäße Sensor ist in die genannten Polster einsetzbar.

Der Sensor besteht aus einem Gehäuse 1 und einem dazu beweglich angeordneten Deckel 2. Der Sensor weist eine Auslöseeinheit 3 auf, die mit einem Sender 4 verbunden ist. Zwischen dem Gehäuse 1 und dem Deckel 2 ist mindestens ein Federelement 5 angeordnet. Im Ausführungsbeispiel sind zwei Federelemente 5 vorgesehen.

Das Gehäuse 1 ist aus Kunststoff hergestellt. Es weist einen Boden 11 auf, der von einer ringförmig umlaufenden Wandung 12 begrenzt ist. An ihrem dem Boden 11 abgewandten Ende weist die Wandung 12 des Gehäuses 1 außen einen umlaufenden Ring 13 auf, der mit einer Einlaufschräge 131 versehen ist. Das Gehäuse 1 ist mit Rippen versehen, durch die verschiedene, voneinander getrennte Bereiche ausgebildet sind. So ist im Zentrum des Gehäuses 1 ein annähernd quadratisch ausgebildetes Fach 15 ausgebildet, das mit Rastnasen 151 versehen ist. An einer Seite des Fachs 15 ist eine Öffnung 152 ausgebildet.

Zu dem Fach 15 benachbart sind an zwei Seiten Aufnahmen 16 für die Federelemente 5 vorgesehen. Am Boden der Aufnahmen 16 sind Zylinder 161 angeordnet, die zur Befestigung der Federelemente 5 dienen. An den beiden anderen Seiten des Fachs 15 ist zu diesem benachbart jeweils eine Wand 17 ausgebildet, die mit Bohrungen 171 versehen ist. Im Anschluss an eine der beiden Wände 17 ist ein zweites Fach 18 vorgesehen, welches zur Anordnung des Senders 4 dient. Das Fach 18 weist Säulen 181 auf, die mit Hinterschneidungen 182 versehen sind und zur nahezu spielfreien Befestigung des Senders 4 in dem Fach 18 dienen.

Der Deckel 2 übergreift das Gehäuse 1 bereichsweise. Er weist einen Rand 21 auf, der den Deckel 2 begrenzt. Der Rand 21 ist an seinem freien Ende mit Rastnasen 22 versehen, die mit Einlaufschrägen 221 versehen sind. Die Rastnasen 22 mit ihren Einlaufschrägen 221 korrespondieren mit dem umlaufenden Ring 13 und dessen Einlaufschräge 131. Die Korrespondenz zwischen dem Ring 13 und den Rastnasen 22 bewirkt eine Begrenzung beim Ausfedern des Sensors. In nicht belastetem Zustand des Sensors steht der Ring 13 mit den Rastnasen 22 in Kontakt. Zudem ist durch die Korrespondenz zwischen Ring 13 und Rastnasen 22 eine zerstörungsfreie Demontage des Sensors verhindert, so dass unbemerkten Manipulationen vorgebeugt ist.

Der Deckel 2 weist auf seiner Innenseite eine Verrippung 23 auf, die zur Erhöhung der Stabilität des Deckels 2 beiträgt. Die Verrippung 23 erstreckt sich gleichmäßig über die Innenseite des Deckels 2 und mündet in einem Kontaktelement 24, welches ringförmig ausgebildet ist.

Die Auslösereinheit 3 besteht aus einem Aktor 31, der in dem Fach 15 montiert ist. Mittels der Rastnasen 151 ist der Aktor 31 in dem Fach 15 geklemmt gehalten. Durch die Verrastung ist eine schraubenlose Montage des Aktors 31 ermöglicht, was die Montage erleichtert und die Dauer der Montage verkürzt. Bei dem Aktor 31 handelt es sich vorzugsweise um einen piezoelektrischen Wandler, bei dem kinetische Energie in elektrische Energie gewandelt wird. In Abwandlung des Ausführungsbeispiels können auch elektrodynamische Energieerzeuger Anwendung finden, bei denen die Energie beispielsweise aus dem Schaltereignis selbst gewonnen wird. Die Verwendung anderer batterie- und kabelloser Energieerzeuger ist ebenfalls denkbar.

Der Aktor 31 weist eine Zunge 32 auf, die an einer Seite über den Aktor 31 hinausragt. In montiertem Zustand ragt die Zunge 32 durch die Öffnung 152 des Fachs 15. Die Auslösereinheit 3 umfasst weiterhin mindestens einen, im Ausführungsbeispiel zwei Hebel 33, die mit dem Aktor 31 zusammenwirken. Die Hebel 33 bestehen aus glasfaserverstärktem Kunststoff. Sie sind nach Art eines Bügels ausgebildet und weisen an ihren beiden Schenkeln jeweils außen einen Zylinder 331 auf. Die Zylinder 331 fassen in montiertem Zustand in die Bohrungen 171 der Wände 17. Über die Kombination der Bohrungen 171 mit den Zylindern 331 sind die Hebel 33 schwenkbar in dem Gehäuse 1 angeordnet. Die Hebel 33 weisen jeweils einen verlängerten Schenkel auf, der an seinem freien Ende einen Schlitz 332 hat. In montiertem Zustand der Hebel 33 fasst die Zunge 32 am Aktor 31 in die Schlitze 332 der Hebel 33. Die Hebel 33 liegen in montiertem Zustand an dem Kontaktelement 24 am Deckel 2 an.

Die Hebel 33 stehen unter dem Einfluss der Federelemente 5, die in den Aufnahmen 16 des Gehäuses 1 angeordnet sind. Die Federelemente 5 sind im Ausführungsbeispiel nach Art einer Blattfeder gebildet. Sie weisen eine Basis 51 auf, die mit einer kreuzschlitzförmigen Öffnung 52 versehen ist. Die Öffnung 52 dient zum Durchtritt der Zylinder 161 in den Aufnahmen 16. Durch die Korrespondenz zwischen den Zylindern 161 mit den Öffnungen 52 sind die Federelemente 5 in dem Gehäuse 1 geklemmt gehalten. Die Federelemente 5 weisen beiderseits der Basis 51 Flügel 53 auf, die sich bogenförmig in Richtung des Deckels 2 erstrecken. Die freien Enden der Flügel 53 liegen in montiertem Zustand an den Schenkeln der Hebel 33 an und drücken diese in Richtung des Deckels 2.

Bei dem Sender 4 handelt es sich im Ausführungsbeispiel um einen Hochfrequenzsender zum drahtlosen Übertragen eines Signals. Der Sender ist außerordentlich strahlungsarm. Es kommen üblicherweise Sender zur Anwendung, die in etwa eine tausendfach geringere Strahlung abgeben als ein üblicher Lichtschalter oder ein übliches Smartphone. Infolgedessen ist der erfindungsgemäße Sensor auch in hochsensiblen Bereichen einsetzbar, beispielsweise auf Intensivstationen von Krankenhäusern. Selbstverständlich besteht auch die Möglichkeit, andere Sender zu verwenden. Beispielsweise kommen Bluetooth- oder Infrarotsender hierfür in Betracht.

Der Sender 4 ist benachbart zum Aktor 31 angeordnet. Dies stellt im Vergleich zu bekannten Sensoren eine Besonderheit da, da üblicherweise die Sender mit den Aktoren eine gemeinsame Baugruppe bilden. Durch die Trennung von Aktor 31 und Sender 4 ist eine wesentlich flachere Bauweise für den Sensor möglich, als dies bei aus dem Stand der Technik bekannten Sensoren der Fall ist. Infolgedessen kann der Sensor auch in flachen Polstern verbaut werden, ohne dass der Sitz- oder Liegekomfort dadurch negativ beeinflusst wird. In montiertem Zustand ist der Sensor 4 in dem Fach 18 angeordnet. Der Sensor 4 weist an zwei gegenüberliegenden Seiten Aussparungen 41 auf, die in montiertem Zustand mit den Säulen 181 des Faches 18 korrespondieren. In montiertem Zustand übergreifen die Hinterschneidungen 182 den Sender 4 bereichsweise, wodurch dieser zuverlässig im Fach 18 gehalten ist. Der Sender 4 ist mit dem Aktor 31 über - nicht dargestellte - Leitungen verbunden.

Bei der Montage des erfindungsgemäßen Sensors werden die Auslöseeinheit 3, der Sender 4 sowie die Federelemente 5 in der oben beschriebenen Weise in das Gehäuse 1 eingesetzt. Sodann wird der Deckel 2 von oben über das Gehäuse 1 geschoben. Mithilfe der Einlaufschrägen 131 am Ring 13 sowie der Einlaufschrägen 221 an den Rastnasen 22 erfolgt eine widerstandsbehaftete Montage des Deckels 2 auf dem Gehäuse 1. Nach dem beiderseitigen Passieren der Einlaufschrägen fassen die Rastnasen 22 hinter den Ring 13. In diesem Zustand liegt der Ring 13 mit seiner äußersten Kante an der Innenseite des Rands 21 des Deckels 2 an, wodurch eine Abdichtung zwischen Gehäuse 1 und Deckel 2 hervorgerufen ist, die einen Staubschutz und Wasserschutz bereitstellt. Die Abdichtung ist dabei derart effektiv, dass sogar ein zeitweises Untertauchen des Sensors unter Wasser nicht zu einer Zerstörung des Sensors führt.

In montiertem Zustand des Deckels 2 auf dem Gehäuse 1 liegen die Hebel 33 unter dem Einfluss der Federelemente 5 mit ihrem die Schenkel verbindenden Mittelteil an dem ringförmigen Kontaktelement 24 an. Aufgrund der gewählten Breite der Hebel 33 ist eine großflächige Kontaktierung zwischen Hebel 33 und Kontaktelement 24 hervorgerufen. Durch die ringförmige Gestaltung des Kontaktelements 24 ist einerseits eine beliebige Montage des Deckels 2 auf dem Gehäuse 1 möglich, ohne Einbußen bei der Auslösung des Sensors hinnehmen zu müssen. Zum anderen ist durch diese Ausgestaltung eine Auslösung um 360° möglich, so dass der erfindungsgemäße Sensor unabhängig von der Lage des Auslösepunkts zuverlässig auslösen kann. Bei aus dem Stand der Technik bekannten Sensoren ist üblicherweise eine Auslösung unmittelbar im Zentrum des Sensors erforderlich, was die Zuverlässigkeit beim Auslösen einschränkt. Der erfindungsgemäße Sensor bietet dagegen die Möglichkeit, auch in einem Umfeld außerhalb des Sensors bei Veränderung des Drucks auf das Polster auszulösen. Je nach gewähltem Polster erfolgt eine zuverlässige Auslösung auch noch in einer Entfernung von ca. 40cm vom Sensor. Zudem ermöglicht die beschriebene konstruktive Ausgestaltung des Sensors ein Kippen des Deckels 2 auf dem Gehäuse 1, was die Auslöseeigenschaften zusätzlich verbessert. Bei bekannten Sensoren führt demgegenüber ein Kippen des Deckels auf dem Gehäuse zu einem Verkanten, wodurch häufig eine Blockade hervorgerufen ist, die eine zuverlässige Funktion des Sensors behindert.

Der erfindungsgemäße Sensor wird in einfacher Weise in das jeweilige Polster eingesetzt. Es sind keine weiteren Hilfsmittel erforderlich, so dass der Sensor einfach in einen in das Polster eingebrachten Hohlraum einsetzbar ist. Der Sensor ist dann in dem jeweiligen Polster schwimmend gelagert. Sobald sich ein Benutzer auf ein Polster setzt oder legt, führt dies zu einer Belastung des dem Benutzer zugewandten Deckels 2, der dadurch jedenfalls bereichsweise in Richtung des Gehäuses 1 bewegt wird. Durch diese Bewegung wird gleichzeitig mindestens ein Hebel 33 entgegen der Kraft der Federelemente 5 in Richtung des Bodens 11 des Gehäuses 1 gedrückt. Hierdurch erfolgt eine Schwenkbewegung des Hebels 33 um die Zylinder 331, wodurch sich das mit dem Schlitz 332 versehene freie Ende des Hebels 33 in Richtung des Deckels 2 bewegt.

Hierdurch erfolgt gleichermaßen eine Bewegung der in dem Schlitz 332 fassenden Zunge 32. In Folge dessen wird der piezo-elektrische Wandler im Aktor 31 mit kinetischer Energie beaufschlagt, wodurch der erforderliche Strom zum Absetzen eines Signals generiert wird. Dieses Signal wird vom Sender 4 an den jeweils ausgewählten Empfänger gesendet. Der durch die kinetische Energie bereit gestellte Strom ist ausreichend, um das Signal zuverlässig zu dem jeweils ausgewählten Empfänger zu übermitteln.

Erhebt sich der Benutzer von dem jeweiligen Polster, wird der Deckel 2 entlastet, was zu einem Ausfedern der Federelemente 5 führt. Unter dem Einfluss der Federkraft werden die Hebel 33 wieder in ihre Ausgangsposition zurückgedrückt, bis die Rastnasen 22 des Deckels 2 an dem Ring 13 des Gehäuses 1 anliegen. Durch diese Bewegung der Hebel 33 wird auch die Zunge 32 bewegt, wodurch erneut elektrische Energie produziert wird. Diese ermöglicht das Absetzen eines Signals durch den Sender 4 an den jeweiligen zugeordneten Empfänger, wodurch der Empfänger erkennt, dass das Polster unbelastet ist.

Der erfindungsgemäße Sensor arbeitet batterie- und kabellos und ist infolgedessen vollständig autark einsetzbar. Auch ist es nicht erforderlich, nach gegebener Zeit den Ladezustand einer Batterie oder dergleichen zu kontrollieren. Infolgedessen ist der Sensor wartungsfrei. Zudem ist der Sensor im nicht betätigten Zustand stromlos, wodurch dieser keine Emmissionen ausstrahlt. Im Falle der Auslösung des Sensors weist er darüber hinaus eine außerordentlich geringere Strahlungsintensität auf, die eine Benutzung in hochsensiblen Bereichen ermöglicht.

Mit dem erfindungsgemäßen Sensor ist es darüber hinaus möglich nicht allein eine Überwachung der Belegung eines Sitzmöbels herbeizuführen, sondern auch eine Steuerung einzelner Geräte oder Verbraucher vorzunehmen. So ist beispielsweise möglich, über den Sensor das Licht eines Raums zu schalten, wenn der Sensor entlastet wird. Dies kann auch mit einer Zeitverzögerung erfolgen, so dass erst nach einigen Minuten nach dem Verlassen des Raumes das Licht abgeschaltet wird. Der Sensor kann zudem mit einem Empfänger gekoppelt werden, der auch andere Signale verarbeitet, beispielsweise Signale von Rauchmeldern, Fensterkontakten oder dergleichen.

## Patentansprüche

1. Sensor zur Erfassung der Belegung von Sitz- und Liegemöbeln, die ein Sitz- oder Liegepolster aufweisen, der aus einem Gehäuse (1) und einem dazu beweglich angeordneten Deckel (2) besteht, wobei zwischen Gehäuse (1) und Deckel (2) mindestens ein Federelement (5) angeordnet ist, und der eine Auslöseeinheit (3) aufweist, die mit einem Sender (4) verbunden ist, **dadurch gekennzeichnet, dass** die Auslöseeinheit (3) aus einem Aktor (31) besteht, der mit mindestens zwei Hebeln (33) zusammenwirkt, welche schwenkbar in dem Gehäuse (1) angeordnet sind und unter dem Einfluss jeweils eines der Federelemente (5) stehen und die mit einem Kontaktelement (24) am Deckel (2) anliegen, und dass das Kontaktelement (24) derart ringförmig ausgebildet ist, dass eine Auslösung um 360° möglich ist.

2. Sensor nach Anspruch 1, **dadurch gekennzeichnet, dass** die Hebel (33) an einem ihrer Enden jeweils einen Schlitz (332) aufweisen, in die jeweils eine Zunge (32) am Aktor (31) fasst.

3. Sensor nach einem der vorgenannten Ansprüche, **dadurch gekennzeichnet, dass** das Federelement (5) nach Art einer Blattfeder gebildet ist.

4. Sensor nach einem der vorgenannten Ansprüche, **dadurch gekennzeichnet, dass** der Aktor (31) benachbart zum Sender (4) angeordnet ist.

5. Sensor nach einem der vorgenannten Ansprüche, **dadurch gekennzeichnet, dass** der Deckel (2) das Gehäuse (1) bereichsweise übergreift.

6. Sensor nach einem der vorgenannten Ansprüche, **dadurch gekennzeichnet, dass** das Gehäuse (1) außen einen umlaufenden Ring (13) aufweist, der mit Rastnasen (22) am Deckel (2) korrespondiert.

7. Sensor nach Anspruch 6, **dadurch gekennzeichnet, dass** der Ring (13) und die Rastnasen (22) jeweils mit Einlaufschrägen (131, 221) versehen sind.

## Claims

1. Sensor for recording the occupancy of seating and reclining furniture having a seat or recliner cushion consisting of a housing (1) and a cover (2) arranged to be movable thereto, wherein at least one spring element (5) is arranged between housing (1) and cover (2), and which has a trigger unit (3), which is connected to a transmitter (4), **characterised in that** the trigger unit (3) consists of an actuator (31), which interacts with at least two levers (33), which are pivotably arranged in the housing (1) and are under the influence of one of the spring elements (5), respectively, and which abut against the cover (2) with a contact element (24) and that the contact element (24) is designed to be annular in such a manner that a 360° triggering is possible.

2. Sensor according to claim 1, **characterised in that** the levers (33) each have a slot (332) at one of their ends, in which a tongue (32) on the actuator (31) respectively engages.

3. Sensor according to one of the previous claims, **characterised in that** the spring element (5) is designed in the manner of a leaf spring.

4. Sensor according to one of the previous claims, **characterised in that** the actuator (31) is arranged adjacent to the transmitter (4).

5. Sensor according to one of the previous claims, **characterised in that** the cover (2) overlaps the housing (1) in some areas.

6. Sensor according to one of the previous claims, **characterised in that** the housing (1) has a circumferential ring (13) on the outside, which corresponds with latching lugs (22) on the cover (2).

7. Sensor according to claim 6, **characterised in that** the ring (13) and the latching lugs (22) are each provided with lead-in bevels (131, 221).

## Revendications

1. Capteur pour détecter l'occupation de sièges et de lits présentant un rembourrage d'assise ou de couchage, composé d'un boîtier (1) et d'un couvercle (2) disposé mobile par rapport à ce dernier, sachant qu'entre le boîtier (1) et le couvercle (2) est disposé au moins un élément ressort (5), et présentant une unité de déclenchement (3) reliée avec un émetteur (4), **caractérisé en ce que** l'unité de déclenchement (3) se compose d'un actionneur (31) qui interagit avec au moins deux leviers (33) disposés de manière à pouvoir pivoter dans le boîtier (1), qui se trouvent sous l'influence respectivement de l'un des éléments ressorts (5) et qui appliquent par un élément de contact (24) contre le couvercle (2), et **en ce que** l'élément de contact (24) est configuré annulaire de telle manière qu'un déclenchement est possible à 360°.

2. Capteur selon la revendication 1, **caractérisé en ce que** les leviers (33) présentent à leurs extrémités respectivement une fente (332) dans laquelle engrène respectivement une languette (32) de l'actionneur (31).

3. Capteur selon l'une des revendications précédentes, **caractérisé en ce que** l'élément ressort (5) a la forme d'un ressort à lame.

4. Capteur selon l'une des revendications précédentes, **caractérisé en ce que** l'actionneur (31) est disposé au voisinage de l'émetteur (4).

5. Capteur selon l'une des revendications précédentes, **caractérisé en ce que** le couvercle (2) dépasse localement le boîtier (1).

6. Capteur selon l'une des revendications précédentes, **caractérisé en ce que** le boîtier (1) présente à l'extérieur un anneau périphérique (13) épousant des saillies de crantage (22) contre le couvercle (2).

7. Capteur selon la revendication 6, **caractérisé en ce que** l'anneau (13) et les saillies de crantage (22) sont respectivement munies de biseaux de pénétration (131, 221).
